(19) Europäisches Patentamt
European Patent Office
Office européen des brevets

(11) **EP 2 475 015 B1**

(12) **EUROPEAN PATENT SPECIFICATION**

(45) Date of publication and mention
of the grant of the patent:
**12.03.2014 Bulletin 2014/11**

(51) Int Cl.:
*H01J 63/04* (2006.01)      *H01J 63/06* (2006.01)
*H01J 1/63* (2006.01)      *C09K 11/64* (2006.01)

(21) Application number: **10811666.6**

(86) International application number:
**PCT/JP2010/063102**

(22) Date of filing: **03.08.2010**

(87) International publication number:
**WO 2011/024615 (03.03.2011 Gazette 2011/09)**

(54) **ULTRAVIOLET LIGHT IRRADIATION DEVICE**

ULTRAVIOLETTLICHTBESTRAHLUNGSVORRICHTUNG

DISPOSITIF D'IRRADIATION À RAYONNEMENT ULTRAVIOLET

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **31.08.2009 JP 2009199454**

(43) Date of publication of application:
**11.07.2012 Bulletin 2012/28**

(73) Proprietors:
• **Kyoto University
Kyoto-shi, Kyoto 606-8501 (JP)**
• **Ushio Denki Kabushiki Kaisha
Tokyo 100-8150 (JP)**

(72) Inventors:
• **OKAMOTO, Koichi
Kyoto-shi
Kyoto 615-8510 (JP)**
• **FUNATO, Mitsuru
Kyoto-shi
Kyoto 615-8510 (JP)**
• **KAWAKAMI, Yoichi
Kyoto-shi
Kyoto 615-8510 (JP)**
• **KATAOKA, Ken
Himeji-shi
Hyogo 671-0224 (JP)**
• **HATA, Hiroshige
Himeji-shi
Hyogo 671-0224 (JP)**

(74) Representative: **Schuster, Thomas
Grünecker Kinkeldey Stockmair &
Schwanhäusser
Anwaltssozietät
Leopoldstrasse 4
80802 München (DE)**

(56) References cited:
WO-A1-2009/072573      JP-A- 2006 190 541
JP-A- 2009 088 519      JP-A- 2010 171 391
US-A1- 2007 176 531      US-A1- 2007 228 986
US-A1- 2008 152 943      US-A1- 2009 087 994

## Description

TECHNICAL FIELD

The present invention relates to an ultraviolet irradiation device equipped with a semiconductor multilayer film element utilizing, for example, a surface plasmon.

BACKGROUND ART

Uses of a small-sized ultraviolet light source are about to spread nowadays. For example, a new art applied to a UV-curable ink jet printer has been developed.

An ultraviolet light-emitting diode (LED) using, for example, a gallium nitride (GaN)-based compound semiconductor is known as an ultraviolet light source, and it is known that light emission in an ultraviolet wavelength range of, for example, 380 nm or less in such an ultraviolet LED can be controlled by changing a compositional ratio of aluminum (Al) in the GaN-based compound semiconductor forming an active layer and containing Al.

Under the circumstances, however, the ultraviolet LED becomes low in external quantum efficiency according to non-radiative transition due to defect in a semiconductor crystal and carrier overflow and resistance loss in the active layer from the construction that a p-type layer, which cannot but become a low carrier density by the presence of p-type impurities high in activated energy, such as, for example, Mg, is required, and is thus not practical.

In recent years, for example, the use of an energy state called surface plasmon polariton has been newly proposed as a method for improving the luminous efficiency of LED (see, for example, non Patent Literature 1). According to non Patent Literature 1, the non-radiative transition due to the defect in the semiconductor crystal can be inhibited by a high density of states of a surface plasmon polariton formed by transferring energy of an exciton generated in, for example, an active layer having a quantum well structure to a surface plasmon at an interface between a metal layer formed of silver and the active layer, thereby enable to improve internal quantum efficiency (to achieve a surface plasmon effect).

In addition, there have been proposed, as arts for achieving the surface plasmon effect, for example, the construction that a first electrode layer good in ohmic contact with a semiconductor layer formed on a light-emitting layer is provided on the semiconductor layer, and a second electrode layer containing a metal having a periodic structure by a concavoconvex form higher in plasma frequency than the first electrode layer, and functioning as a plasmon-generating layer is provided on this first electrode layer (see Patent Literature 1), and a semiconductor light-emitting element 40 of the construction that plural columnar bodies each formed by a semiconductor multilayer film containing an active layer 43 and a p electrode 47 are periodically formed, and a plasmon-generating layer 48 formed of a metal is embedded in around each columnar body as illustrated in FIG. 11 (see Patent Literature 2). In FIG. 11, reference sign 41 designates a transparent substrate, 42 an n-type contact layer, 44 an overflow-inhibiting layer, 45 a p-type contact layer, and 49 an n electrode.

CITATION LIST

PATENT LITERATURE

Patent Literature 1: Japanese Patent No. 4130163
Patent Literature 2: Japanese Patent Application Laid-Open No. 2007-214260

NON PATENT LITERATURE

Non Patent Literature 1: Monthly Display, No. February, 2009, Separate Volume, page 10 to page 16

SUMMARY OF INVENTION

Technical Problem

In order to enhance light emission in an ultraviolet wavelength range in the LED utilizing the surface plasmon, it is known to preferably use aluminum as a metal making up a plasmon-generating layer. However, when the plasmon-generating layer is formed by aluminum, good ohmic contact with, for example, a nitride semiconductor or zinc oxide mainly used as a material forming a p-type electrode layer cannot be conducted.

In addition, in order to efficiently conduct energy transfer from an exciton generated in an active layer (light-emitting layer) to a surface plasmon, it is necessary that a distance between the active layer (light-emitting layer) and the plasmon-generating layer is short. However, the art described in Patent Literature 1 involves problems that not only difficulty is encountered upon realizing the improvement in the luminous efficiency utilizing the surface plasmon because the distance between the light-emitting layer and the plasmon-generating layer is, for example, several hundreds nanometers or more away from the construction that the p-type electrode layer is required between the light-emitting layer and the plasmon-generating layer, but also difficulty is encountered upon sufficiently exciting the surface plasmon polariton because the first electrode layer is present between the light-emitting layer and the second metal layer (plasmon-generating layer) high in plasma frequency.

On the other hand, the art described in Patent Literature 2 involves a problem that a complicated production process is required because there is need to form a particular electrode structure for providing the semiconductor light-emitting element as one having the construction capable of achieving the surface plasmon effect.

The present invention has been made on the basis of the foregoing circumstances and has as its object the provision of an ultraviolet irradiation device that has a simple structure making no use of pn junction, can efficiently utilize a surface plasmon polariton and can emit ultraviolet light of a specific wavelength at high efficiency.

Solution to Problem

An ultraviolet irradiation device according to the present invention comprises at least one semiconductor multilayer film element and an electron beam irradiation source for irradiating the semiconductor multilayer film element with electron beams which are provided in a container having an ultraviolet-ray transmitting window and vacuum-sealed, wherein

the semiconductor multilayer film element has an active layer formed of $In_xAl_yGa_{1-x-y}N$ (wherein $0 \leq x < 1$, $0 < y \leq 1$, and $x + y \leq 1$) and having a single quantum well structure or a multiple quantum well structure and a metal film formed on an upper surface of the active layer, composed of metal particles of aluminum or an aluminum alloy and having a nanostructure formed of the metal particles, and wherein

ultraviolet light is emitted to the outside through the ultraviolet-ray transmitting window by irradiating the semiconductor multilayer film element with the electron beams from the electron beam irradiation source.

In the ultraviolet irradiation device according to the present invention, the metal particles forming the metal film may preferably have a particle size within a range represented by the following expression (1):
[Math. 1]

Expression(1)

$$\frac{\lambda}{\sqrt{\frac{\varepsilon'_m(\lambda)\varepsilon_b(\lambda)}{\varepsilon'_m(\lambda)+\varepsilon_b(\lambda)}} + \sqrt{\varepsilon_b(\lambda)}} \leq a \leq \frac{\lambda}{\sqrt{\frac{\varepsilon'_m(\lambda)\varepsilon_b(\lambda)}{\varepsilon'_m(\lambda)+\varepsilon_b(\lambda)}} - \sqrt{\varepsilon_b(\lambda)}}$$

wherein $\lambda$ is a wavelength [nm] of the ultraviolet light emitted from the semiconductor multilayer film element, a is the particle size [nm] of the metal particles forming the metal film, $\varepsilon'_m(\lambda)$ is a real part of a dielectric function of the metal film, and $\varepsilon_b(\lambda)$ is a dielectric function of a semiconductor layer in contact with the metal film.

In addition, in the ultraviolet irradiation device according to the present invention, the wavelength of the ultraviolet light emitted from the semiconductor multilayer film element may be within a range of 220 to 370 nm.

Further, in the ultraviolet irradiation device according to the present invention, the metal film in the semiconductor multilayer film element may be irradiated with the electron beams from the electron beam irradiation source.

Furthermore, in the ultraviolet irradiation device according to the present invention, the semiconductor multilayer film element may be arranged on an inner surface of the ultraviolet-ray transmitting window, and the electron beam irradiation source may be arranged in opposition to the metal film in the semiconductor multilayer film element.

ADVANTAGEOUS EFFECTS OF INVENTION

Since the semiconductor multilayer film element according to the present invention is so constructed that in the light-emitting mechanism that the surface plasmon polariton formed by transferring energy of the exciton excited in the active layer to the surface plasmon at the interface between the active layer and the metal film is taken out, the exciton is formed (excited) by electron beam irradiation by which relatively high energy can be supplied, the amount of the exciton generated can be increased, and moreover the problem that the external quantum efficiency becomes low by carrier overflow and resistance loss in the active layer is not caused. In addition, the degree of the non-radiative recombination of the exciton due to crystal defects such as dislocation can be reduced by the high density of states of the surface plasmon polariton, so that internal quantum efficiency can be improved.

Further, the surface plasmon polariton at the interface between the active layer and the metal film can be taken out as light of the specific wavelength by the function of the nano-structure by the metal particles forming the metal film, so that the structure of the semiconductor multilayer film element can be simplified and easily produced.

Accordingly, the ultraviolet irradiation device equipped with such a semiconductor multilayer film element can emit ultraviolet light having the specific wavelength at high efficiency.

Furthermore, the metal particles forming the metal film in the semiconductor multilayer film element have the particle size within the specific range, whereby the wave number of the surface plasmon polariton at the interface between the metal film and the active layer can be modulated by the function of the grain structure (nano-structure) by the metal particles to surely take out the ultraviolet light having the specific wavelength, so that high light extraction efficiency can be achieved. Accordingly, the luminous efficiency of the semiconductor multilayer film element can be surely improved.

BRIEF DESCRIPTION OF DRAWINGS

FIG. 1 is a cross-sectional view schematically illustrating the construction of an exemplary ultraviolet irradiation device according to the present invention.

FIG. 2 is a cross-sectional view schematically illustrating the construction of an exemplary semiconductor multilayer film element in the ultraviolet irradiation device according to the present invention.

FIG. 3 is an enlarged cross-sectional view schematically illustrating a part of the semiconductor multilayer film element illustrated in FIG. 2.

FIG. 4 is a graph illustrating energy conversion efficiency from an exciton to a surface plasmon at an interface between an AIN barrier layer and an A1 film.

FIG. 5 is a graph illustrating a dispersion curve of a surface plasmon polariton at the interface between the AIN barrier layer and the Al film.

FIG. 6 typically illustrates a grain structure by metal particles forming a metal film.

FIG. 7 is an explanatory view illustrating the relationship between the dispersion curve of the surface plasmon polariton and a light cone (light-emitting range).

FIG. 8 is an explanatory view illustrating an upper limit value and a lower limit value of a particle size of metal particles, which are required of a grain structure for transferring the dispersion curve of the surface plasmon polariton within the light cone by zone folding.

FIG. 9 is a graph illustrating the dependency of an optimum value of a grain size of a grain structure in a metal film on a wavelength.

FIG. 10 is illustrates explanatory views schematically illustrating the construction of another exemplary ultraviolet irradiation device according to the present invention, wherein (A) is a cross-sectional view, and (B) is a plan view viewed from the side of an electron beam irradiation source.

FIG. 11 is a perspective view illustrating the construction of a conventional semiconductor light-emitting element utilizing a surface plasmon.

DESCRIPTION OF EMBODIMENTS

Embodiments of the present invention will hereinafter be described in detail.

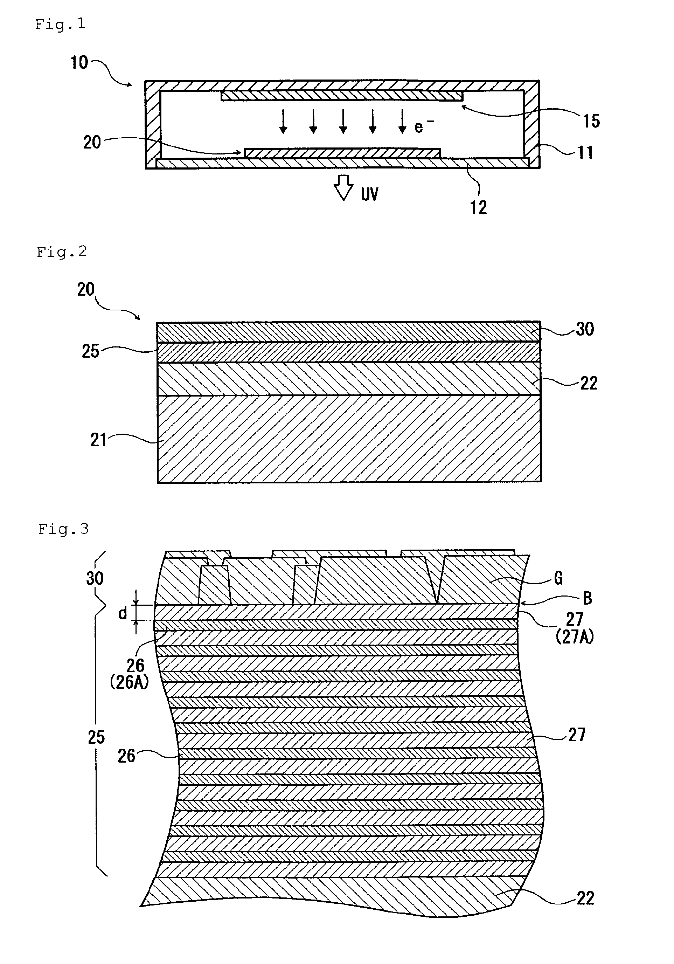

FIG. 1 is a cross-sectional view schematically illustrating the construction of an exemplary ultraviolet irradiation device according to the present invention, and FIG. 2 is a cross-sectional view schematically illustrating the construction of an exemplary semiconductor multilayer film element in the ultraviolet irradiation device according to the present invention.

This ultraviolet irradiation device 10 is equipped with a vacuum container 11 composed of, for example, glass and formed into a box-shaped casing, an opening formed in which is airtightly closed with an ultraviolet-ray transmitting window 12 to seal an internal space thereof in, for example, a vacuum state, and is constructed by arranging a semiconductor multilayer film element 20 on an inner surface of the ultraviolet-ray transmitting window 12 within the vacuum container 11 and providing an electron beam irradiation source 15 for irradiating the semiconductor multilayer film element 20 with electron beams at a position opposing the semiconductor multilayer film element 20.

As examples of the electron beam irradiation source 15, may be mentioned a spindt-type filed emitter of a structure that a gate electrode for drawing an electron is closely arranged around a conical Mo tip.

The semiconductor multilayer film element 20 is formed by a substrate 21 composed of, for example, sapphire, a buffer layer 22 formed on one surface of this substrate 21 and composed of, for example, AlN, an active layer 25 formed on one surface of this buffer layer 22 and having a single quantum well structure or a multiple quantum well structure, and a metal film 30 formed on one surface of this active layer 25 and formed of metal particles composed of aluminum or an aluminum alloy.

The semiconductor multilayer film element 20 in this embodiment is so constructed that the substrate 21 is fixed to the ultraviolet-ray transmitting window 12 with a UV-curable resin in a state that the metal film 30 has been exposed to the electron beam irradiation source 15, and the semiconductor multilayer film element is thus irradiated from the side of the metal film 30 with electron beams from the electron beam irradiation source 15.

A constructional example of the active layer 25 having the multiple quantum well structure is illustrated. As illustrated in FIG. 3, for example, ten barrier layers 27 each composed of, for example, AlN and, for example, ten quantum well layers 26 each composed of $In_xAl_yGa_{1-x-y}N$ (wherein $0 \leq x < 1$, $0 < y \leq 1$, and $x + y \leq 1$) are alternately stacked, and a barrier layer 27A composed of, for example, AlN is additionally grown on one surface of the uppermost quantum well layer 26A, thereby forming the active layer 25.

The thickness of each quantum well layer 26 is set equally to or thinner than a diameter of an exciton generated by electron beam irradiation, and the thickness of each barrier layer 27 is set more greatly than a well width of the quantum well layer 26.

A distance d between one surface of the uppermost quantum well layer 26A and the other surface of the metal film 30, i.e., the thickness of the uppermost barrier layer 27A is preferably, for example, 10 to 20 nm. The transfer of energy from the exciton generated in the active layer 25 to a surface plasmon at an interface B between the uppermost barrier layer 27A and the metal film 30 can thereby be efficiently caused to form a surface plasmon polariton at high efficiency.

In the case where the active layer 25 is formed by the multiple quantum well structure, the period number of the quantum well layers 26 is actually, for example, 1 to 100.

As described below, the metal film 30 has a nanostructure (grain structure) by metal particles having a specific particle size (grain size).

The thickness of the metal film 30 is preferably, for example, 2 nm to 10 $\mu$m.

In addition, when the metal film 30 is formed of metal particles of an aluminum alloy, the proportion of aluminum contained therein is preferably 50% or higher. As examples of other metals making up the aluminum alloy, may be mentioned silver.

A constructional example of the semiconductor multilayer film element 20 is given. The thickness of the sapphire substrate (21) is, for example, 50 $\mu$m, the thickness of the AlN buffer layer (22) is, for example, 600 nm, the well width (thickness) of the $Al_{0.79}Ga_{0.21}N$ quantum well layer (26) is 11 nm, the thickness of the AlN barrier layer (27) is 13.5 nm, the period number of the quantum well layers 26 is ten, and the thickness of the aluminum film (30) is, for example, 50 nm.

A method for preparing the semiconductor multilayer film element 20 of the above-described construction is described. A semiconductor multilayer film in the semiconductor multilayer film element 20 can be formed by, for example, MOCVD method. More specifically, first, a carrier gas composed of hydrogen and nitrogen and a raw material gas composed of trimethyl-aluminum and ammonia are used to grow a buffer layer 22 composed of AlN on (0001) plane of a sapphire substrate 21 so as to give a predetermined thickness. A carrier gas composed of hydrogen and nitrogen and a raw material gas composed of trimethyl-aluminum, trimethylgallium and ammonia are then used in a state retained at a predetermined growth temperature (for example, 1,000 to 1,200°C) and a predetermined growth pressure (for example, 76 Torr (1 x 10$^4$ Pa)) to alternately grow a barrier layer 27 composed of AlN and having a predetermined thickness and a quantum well layer 26 composed of AlGaN and having a predetermined thickness on the buffer layer 22, thereby forming an active layer 25 having a multiple quantum well structure of a predetermined period number. A barrier layer 27A composed of AlN is additionally grown on the uppermost quantum well layer 26A, whereby the semiconductor multilayer film can be formed. Here, conditions such as growth rate and growth temperature for the AlN buffer layer 22, the AlN barrier layer 27 and the AlGaN quantum well layer 26 can be suitably set according to their purposes.

In addition, when InAlGaN is grown as the quantum well layer 26, it is only necessary to use trimethylindium as a raw material gas in addition to those described above and set the growth temperature lower than that of AlGaN.

Incidentally, the method for forming the semiconductor multilayer film is not limited to the MOCVD method. For example, MBE method may also be used.

Metal particles having a particle size falling within a particle size range, which will be described subsequently, and composed of aluminum or an aluminum alloy are then vacuum-deposited on the whole surface of the uppermost barrier layer 27A so as to give a predetermined thickness, thereby forming the metal film 30 having a nano-structure by the metal particles. Thus, the semiconductor multilayer film element 20 of the above-described construction can be obtained.

Alternatively, the metal film 30 having the nano-structure may also be obtained by developing proper nano-microparticles having an even particle size on the uppermost barrier layer 27A, vacuum-depositing the metal particles thereon and then conducting annealing to form a nano-island structure.

The light-emitting mechanism of the ultraviolet irradiation device 10 (semiconductor multilayer film element 20) will hereinafter be described.

In this ultraviolet irradiation device 10, the semiconductor multilayer film element 20 is irradiated with electron beams e- from the electron beam irradiation source 15, whereby an exciton is excited in the active layer 25, and the exciton (electron, hole) is combined (transfer of energy from the exciton) with a surface plasmon (hereinafter referred to as "SP") at an interface B between the active layer 25 and the metal film 30 by recombination of the exciton to form a surface plasmon polariton (hereinafter referred to as "SPP").

The wave number of the SPP is then modulated by the function of the nano-structure by the metal particles forming the metal film 30, whereby the SPP is taken out of the interface B as light, and ultraviolet light having a wavelength of 220 to 370 nm is emitted to the outside through the ultraviolet-ray transmitting window 12.

Factors determining the luminous efficiency of the semiconductor multilayer film element 20 include, for example, (A) exciton-forming efficiency that the exciton is formed, (B) internal quantum efficiency that the exciton becomes light upon recombination and (C) light extraction efficiency that the light generated is taken out to the outside. The luminous efficiency of the semiconductor multilayer film element 20 can be improved by improving these efficiencies.

Since the semiconductor multilayer film element 20 is so constructed that the exciton is formed by the electron beam irradiation as described above, and so high energy can be supplied compared with the construction that the exciton is excited by current injection making use of pn junction, the amount of the exciton to be formed can be increased.

The internal quantum efficiency in the semiconductor multilayer film element 20 will now be described. The semiconductor multilayer film element 20 is regarded as that forming SP eigenfrequency of $\omega_{SP}$.

First, a light emission rate (an inverse number of a light emission lifetime) $k^0_{PL}$ measured by time-resolved PL measurement or the like in a sample (semiconductor multilayer film element) of a structure having no metal film is represented by a sum of a radiative recombination lifetime $k_{rad}$ and a non-radiative recombination lifetime $k_{non}$ as shown by the following expression (2).

[Math. 2]

$$\mathrm{Expression\,(2)} \quad k^0_{PL}(\omega) = k_{rad}(\omega) + k_{non}(\omega)$$

At this time, the internal quantum efficiency $\eta^0$ is given by the following expression (3).

[Math. 3]

$$\mathrm{Expression\,(3)} \quad \eta^0(\omega) = \frac{k_{rad}(\omega)}{k_{rad}(\omega) + k_{non}(\omega)}$$

On the other hand, when SPP has been formed at the interface B between the uppermost barrier layer 27A and the metal film 30 in a sample (semiconductor multilayer film element) in which the metal film 30 is formed, i.e., energy has been transferred from the exciton to SP, a light emission rate (an inverse number of a light emission lifetime) $k^*_{PL}$ measured by time-resolved PL measurement or the like becomes greater by a degree of an energy transfer rate $k_{SPC}$ from the exciton to SP as shown by the following expression (4). In other words, a light emission lifetime becomes shorter by a degree of the energy transfer rate $k_{SPC}$ from the exciton to SP.

[Math. 4]

$$\text{Expression}\,(4)\quad k_{PL}^{*}(\omega) = k_{rad}(\omega) + k_{non}(\omega) + k_{SPC}(\omega)$$

Efficiency (exciton-SPP energy conversion efficiency) $\eta'$ that SPP is formed by energy transfer (recombination radiation) from the exciton to SP is represented by the following expression (5).
[Math. 5]

$$\text{Expression}\,(5)\quad \eta'(\omega) = \frac{k_{SPC}(\omega)}{k_{rad}(\omega) + k_{non}(\omega) + k_{SPC}(\omega)}$$

Here, efficiency (SPP-photon energy conversion efficiency) $\eta''$ that SPP propagating along the interface B between the uppermost barrier layer 27A and the metal film 30 is emitted (taken out) as light from the interface is represented by the following expression (6) using a rate $k_{ext}$ that the SPP is emitted as light and a loss rate $k_{loss}$ by dumping.
[Math. 6]

$$\text{Expression}\,(6)\quad \eta''(\omega) = \frac{k_{ext}(\omega)}{k_{ext}(\omega) + k_{loss}(\omega)}$$

Accordingly, final internal quantum efficiency $\eta)^*$ enhanced by the action of the SPP is represented by a sum of internal quantum efficiency related to the radiative recombination and internal quantum efficiency related to the light emission from SPP as shown by the following expression (7).
[Math. 7]

$$\text{Expression}\,(7)\quad \eta^{*}(\omega) = \frac{k_{rad}(\omega) + \eta''(\omega)\,k_{SPC}(\omega)}{k_{rad}(\omega) + k_{non}(\omega) + k_{SPC}(\omega)}$$

In the expression (7), $k_{ext}$ and $k_{loss}$ are phenomena taken place in a range of femtoseconds (fs) and greatly different from $k_{rad}$ and $k_{non}$ taken place in a range of nanoseconds (ns) in time scale, so that the internal quantum efficiency related to the light emission from SPP may be merely represented by a product between the SPP-photon energy conversion efficiency $\eta''$ shown by the expression (6) as above and the energy transfer rate $k_{SPC}$ from the exciton to the SP.

On the other hand, the energy transfer rate $k_{SPC}$ from the exciton to the SP is represented by the following expression (8) according to Fermi's Golden Rule.
[Math. 8]

$$\text{Expression}\,(8)\quad k_{SPC}(\omega) = \frac{2\pi}{\hbar}\,|\,\vec{d}\cdot\vec{E}(\omega)\,|^{2}\,\rho(\omega)$$

In the expression (8), h is a rationalized Planck's constant represented by h(Planck's constant)/$2\pi$, d is a dipole moment when recombination of an electron-hole pair is electrically dipole-approximated, $E(\omega)$ is electric field strength of SPP in the vicinity of the exciton, and $\rho(\omega)$ is a SPP density of states that is proportional to a gradient ($dk_x/d\omega$) of a dispersion curve of SPP.

With respect to the energy transfer rate $k_{SPC}$ from the exciton to the SP, when the radiative recombination lifetime $k_{rad}$ of the original exciton is considered to be amplified by a high density of states of SPP formed, an amplification factor F may be defined by the following expression (9), and the energy transfer rate $k_{SPC}$ from the exciton to the SP is proportional to the gradient ($dk_x/d\omega$) of the dispersion curve, so that the amplification factor F is considered to be proportional to the gradient ($dk_x/d\omega$) of the dispersion curve.

[Math. 9]

$$\text{Expression}\,(9) \qquad F(\omega) = \frac{k_{SPC}(\omega)}{k_{rad}(\omega)}$$

Accordingly, the exciton-SPP energy conversion efficiency $\eta'$ is determined by the light emission lifetime $k^{*}_{PL}$ of the active layer and the amplification factor (amplification rate) F from the expressions (4), (5) and (9) .

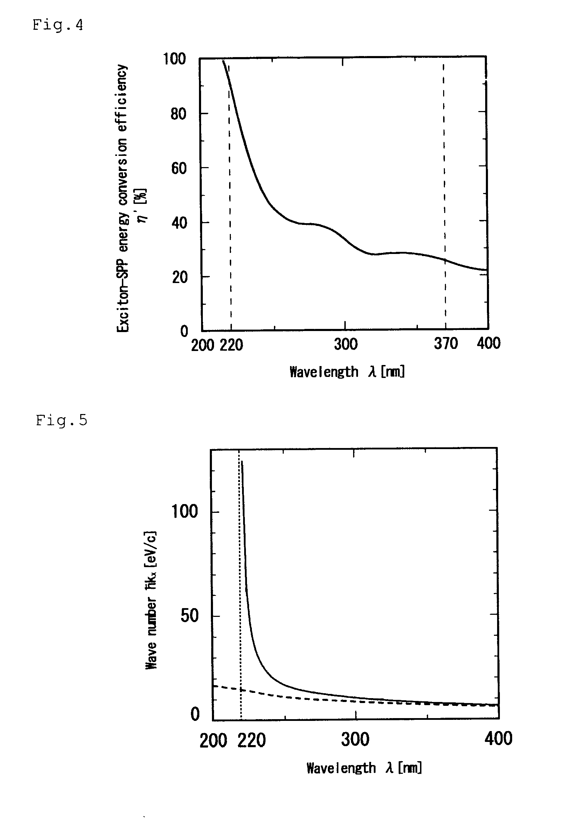

With respect to an example where the light emission lifetime $k^{*}_{PL}$ of the active layer 25 is 1 ns, and the internal quantum efficiency is 10% in the above, the exciton-SPP energy conversion efficiency $\eta'$ was calculated out. As a result, the transfer of energy from the exciton to the SP efficiently occurred in an ultraviolet wavelength range of 220 nm or longer as illustrated in FIG. 4, which indicates that the exciton-SPP energy conversion efficiency $\eta'$ becomes high. This fact indicates that the energy of the exciton is transferred to the SP, whereby loss by non-radiative transition (dissipation or non-radiative recombination by the exciton trapping at crystal defects of the exciton (electron or hole) due to the crystal defect) caused by crystal defect is reduced, thereby improving the internal quantum efficiency.

The light extraction efficiency in the semiconductor multilayer film element 20 is then described.

For example, the dispersion curve (indicated by a solid line in FIG. 5) of SPP formed at the interface B between the AIN barrier layer 27 and the aluminum film 30 is present on a lower energy side than an SP frequency (indicated by a dotted line in FIG. 5) calculated out from dielectric functions of Al and AIN and tends not to intersect a light line indicated by a broken line, so that there is need to modulate the wave number of the SPP for taking out the SPP as light from the interface B between the AIN barrier layer 27A and the aluminum film 30. Here, the SP frequency ($\omega_{SP}$) at the interface B between the AIN barrier layer 27A and the aluminum film 30 is a frequency corresponding to light having a wavelength of 220 nm. FIG. 5 indicates that the wave number of the SPP is modulated, specifically, lessened, whereby the SPP can be effectively utilized in an ultraviolet wavelength range longer than 220 nm, in particular, an ultraviolet wavelength range of 220 to 370 nm (that the surface plasmon effect is achieved).

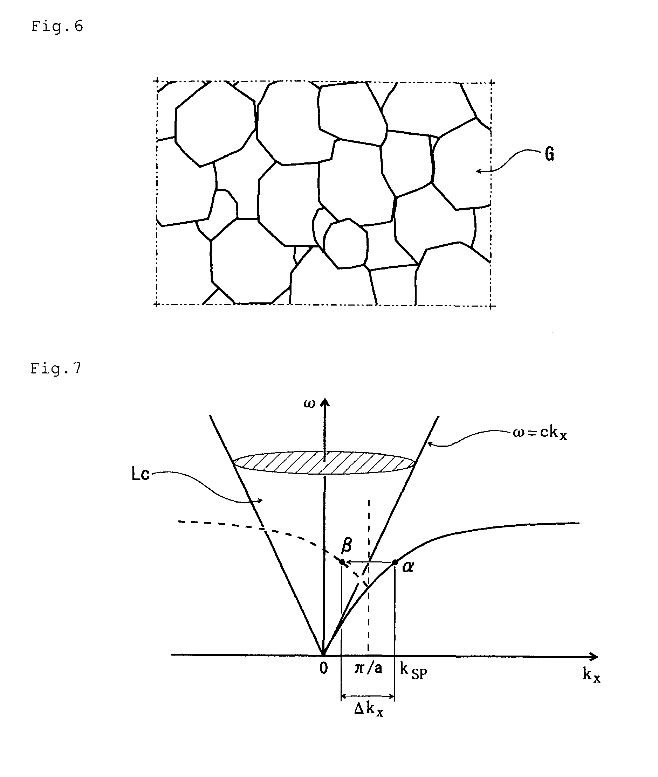

In the semiconductor multilayer film element 20, the metal film 30 has a nano-structure by the metal particles forming the metal film 30, specifically, a grain structure by polycrystals with the grain sizes of the respective crystal grains G of the metal particles adjusted to proper sizes at the surface (interface) of the metal film 30 as illustrated in FIG. 6, and the wave number of the SPP formed at the interface B between the AIN barrier layer 27A and the aluminum film 30 can be modulated by the grain structure.

Here, regarding the grain size (particle size of the metal particles) a of each crystal grain G, a size that an interval between two parallel lines by which the crystal grain G is sandwiched becomes maximum is defined as a maximum particle size, and a size that the interval becomes minimum is defined as a minimum particle size. However, "particle size" means both maximum particle size and minimum particle size unless expressly noted. In short, a range defined about the particle size of metal particles which will be described subsequently means that both maximum particle size $a_{max}$ and minimum particle size $a_{min}$ of the metal particles satisfy the specific relationship.

The grain size can be confirmed by a scanning electron microscope, atomic force microscope or the like.

For example, in order to forming a grain structure required for taking out the SPP propagating along the interface B between the AIN barrier layer 27A and the metal film 30 as light, i.e., for causing energy conversion from the SPP to a photon, the metal particles forming the metal film 30 preferably have a particle size (grain size) a satisfying the expression (1) .

A range of the particle size a of the metal particles defined by the expression (1) is set in the following manner.

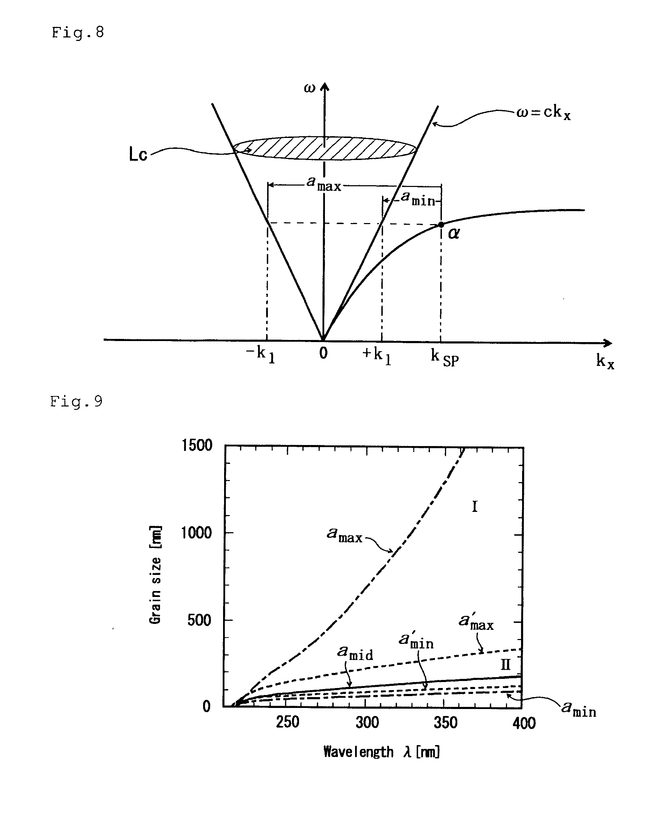

When a wave number is modulated ($\Delta k_x = 2\pi/a$) in such a manner that a position $\alpha$ of a wave number $k_{SP}$ is transferred at a position P having a wave number in an inside range of a light cone (light-emitting range) Lc by folding a dispersion curve of SPP located in an outside range of the light cone Lc at a position of a wave number of $\pi/a$ by zone folding by the function of a grain structure by metal particles of a grain size a as illustrated in FIG. 7, an upper limit value $a_{max}$ and a lower limit value $a_{min}$ of the grain size a are represented by the following expression (10) on the basis of FIG. 8.
[Math. 10]

Expression(10)

$$\Delta k_x = k_{SP} - k_1 = \frac{2\pi}{a_{max}} \quad , \quad \Delta k_x = k_{SP} + k_1 = \frac{2\pi}{a_{min}}$$

Here, the wave number $k_{SP}$ at the position $\alpha$ on the dispersion curve of the SPP in the outside range of the light cone Lc and a wave number $k_1$ at a boundary position (position on a straight line indicated by $\omega = ck_x$) of the light cone Lc are represented by the following expression (11).
[Math. 11]

Expression(11)

$$k_{SP}(\omega) = \frac{\omega}{c}\sqrt{\frac{\varepsilon'_m(\omega)\varepsilon_b(\omega)}{\varepsilon'_m(\omega) + \varepsilon_b(\omega)}} \quad , \quad k_1(\omega) = \frac{\omega}{c}\sqrt{\varepsilon_b(\omega)}$$

Accordingly, the upper limit value $a_{max}$ and the lower limit value $a_{min}$ of the grain size are represented by the following expression (12) when the values are rewritten by expression making use of a wavelength $\lambda$ utilizing the relationship of $\omega = 2\pi c/\lambda$, from the expressions (10) and (11).
[Math. 12]

Expression(12)

$$a_{max}(\lambda) = \frac{\lambda}{\sqrt{\dfrac{\varepsilon'_m(\lambda)\varepsilon_b(\lambda)}{\varepsilon'_m(\lambda) + \varepsilon_b(\lambda)}} - \sqrt{\varepsilon_b(\lambda)}}$$

$$a_{min}(\lambda) = \frac{\lambda}{\sqrt{\dfrac{\varepsilon'_m(\lambda)\varepsilon_b(\lambda)}{\varepsilon'_m(\lambda) + \varepsilon_b(\lambda)}} + \sqrt{\varepsilon_b(\lambda)}}$$

In addition, in the structure of the metal film 30 composed of aluminum, a range of a particle size a' [nm] of the metal particles for forming a grain structure required for causing energy conversion from SPP scattered by the grain structure to light (photon) within a range (angle to the surface of the AIN barrier layer 27A) that is taken out to the outside without being subjected to total reflection on the surface of the AIN barrier layer 27A is represented by the following expression (13).
[Math. 13]

Expression(13)

$$\frac{\lambda}{\sqrt{\dfrac{\varepsilon'_{Al}(\lambda)\,\varepsilon_{AlN}(\lambda)}{\varepsilon'_{Al}(\lambda)+\varepsilon_{AlN}(\lambda)}}+1} \leq a' \leq \frac{\lambda}{\sqrt{\dfrac{\varepsilon'_{Al}(\lambda)\,\varepsilon_{AlN}(\lambda)}{\varepsilon'_{Al}(\lambda)+\varepsilon_{AlN}(\lambda)}}-1}$$

The expression (13) is derived in the following manner. When the SPP at the interface B between the AlN barrier layer 27A and the aluminum film 30 is considered to be emitted as light of an angle of $\pm\theta$ to the surface of the AlN barrier layer 27A from the interface B, the wave number $k_{SP}$ at the position $\alpha$ in an outside range of the light cone Lc on the dispersion curve of the SPP is represented by the following expression (14).
[Math. 14]

Expression(14)

$$k_{SP}(\omega) = \frac{\omega}{c}\sqrt{\frac{\varepsilon'_{Al}(\omega)\,\varepsilon_{AlN}(\omega)}{\varepsilon'_{Al}(\omega)+\varepsilon_{AlN}(\omega)}} = \frac{2\pi}{a} \pm n_{AlN}\frac{\omega}{c}\sin\theta$$

Here, a critical angle that the light can be taken out from the AlN layer to the air is $\sin\theta = n_{air}/n_{AlN}$ from the conditions of the total reflection, so that the following expression (15) is obtained when the upper limit value $a'_{max}$ and the lower limit value $a'_{min}$ of the grain size are rewritten by expression making use of a wavelength $\lambda$ utilizing the relationship of $\omega = 2\pi c/\lambda$, from the expression (14).
[Math. 15]

Expression(15)

$$a'_{max}(\lambda) = \frac{\lambda}{\sqrt{\dfrac{\varepsilon'_{Al}(\lambda)\,\varepsilon_{AlN}(\lambda)}{\varepsilon'_{Al}(\lambda)+\varepsilon_{AlN}(\lambda)}}-1}$$

$$a'_{min}(\lambda) = \frac{\lambda}{\sqrt{\dfrac{\varepsilon'_{Al}(\lambda)\,\varepsilon_{AlN}(\lambda)}{\varepsilon'_{Al}(\lambda)+\varepsilon_{AlN}(\lambda)}}+1}$$

When the particle size $a_{mid}$ of the metal particles is a size represented by the following expression (16), the particle size $a_{mid}$ is a grain size that the wave number $k_x$ of the SPP is folded by zone folding and becomes 0, i.e., a central grain size that the SPP is emitted as light in a vertical direction, by which the energy conversion from the SPP to the photon occurs at the highest efficiency.
[Math. 16]

Expression(16)

$$a_{\mathrm{mid}}(\lambda) = \frac{\lambda}{\sqrt{\dfrac{\varepsilon'_{\mathrm{Al}}(\lambda)\,\varepsilon_{\mathrm{AlN}}(\lambda)}{\varepsilon'_{\mathrm{Al}}(\lambda) + \varepsilon_{\mathrm{AlN}}(\lambda)}}}$$

When the dependency of a particle size range of the metal particles for forming a grain structure required for causing the energy conversion from the SPP to the photon on a wavelength is summarized from the above, light extraction efficiency about a certain specific wavelength can be improved by forming a nanostructure by metal particles having a particle size within a range (a region I surrounded by an $a_{max}$ curve and an $a_{min}$ curve each indicated by an alternate long and short dash line) at least defined by the expression (1) as illustrated in FIG. 9. When the metal film 30 is formed by aluminum, light extraction efficiency about a certain specific wavelength can be improved by forming a nano-structure by aluminum particles having a particle size within a range (a region II surrounded by an $a'_{max}$ curve and an $a'_{min}$ curve each indicated by a broken line) defined by the expression (13), and the highest light extraction efficiency can be obtained by forming a nano-structure by metal particles having a particle size $a_{mid}$ of a curve indicated by a solid line.

In the above, the adjustment of the grain size in the grain structure of the metal film 30 can be conducted by, for example, controlling a deposition rate upon the formation of the metal film 30.

Since the semiconductor multilayer film element 20 of the above-described construction is so constructed that in the light-emitting mechanism that the SPP formed by transferring energy of the exciton excited in the active layer 25 to the SP at the interface B between the AlN barrier layer 27A and the metal film 30 is taken out, the exciton is formed (excited) by the electron beam irradiation by which relatively high energy can be supplied, the amount of the exciton formed can be increased, and moreover the problem that the external quantum efficiency becomes low by carrier overflow and resistance loss in the active layer 25 is not caused. In addition, the degree of the non-radiative recombination of the exciton due to crystal defects such as dislocation can be reduced by the high density of states of the SPP, so that internal quantum efficiency can be improved.

Further, the SPP at the interface B between the AlN barrier layer 27A and the metal film 30 can be taken out as ultraviolet light having a wavelength of 220 to 370 nm by the function of the nano-structure by the metal particles forming the metal film 30. Accordingly, the semiconductor multilayer film element 20 comes to have high luminous efficiency.

Accordingly, the ultraviolet irradiation device 10 equipped with such a semiconductor multilayer film element 20 can emit ultraviolet light having the specific wavelength at high efficiency.

Furthermore, the metal particles forming the metal film 30 of the semiconductor multilayer film element 20 have the particle size a within the specific range, whereby the wave number of the SPP at the interface B between the AlN barrier layer 27A and the metal film 30 can be modulated by the function of the grain structure (nano-structure) by the metal particles to surely take out the SPP as ultraviolet light having a wavelength of 220 to 370 nm, so that high light extraction efficiency can be achieved. Accordingly, the luminous efficiency of the semiconductor multilayer film element 20 can be surely improved.

An experimental example that was conducted for confirming the effects of the present invention will hereinafter be described.

According to the construction illustrated in FIG. 1 to FIG. 3, a spindt-type filed emitter was used as an electron beam irradiation source, a semiconductor multilayer film element (dimension: 1 x 1 x 0.5 mm) of the construction (see paragraph 0026) exemplified above was used to prepare an ultraviolet irradiation device according to the present invention, and the semiconductor multilayer film element was irradiated with electron beams at an electron beam dosage of 10 mA/cm$^2$. As a result, it was confirmed that ultraviolet light having a wavelength of 250 nm is emitted at luminous intensity strengthened to about twice as much as that of a semiconductor multilayer film element having the same structure except that no metal film is provided.

Although the embodiment of the present invention has been described above, the present invention is not limited to the above-described embodiment, and various changes or modifications may be added to the embodiment.

For example, the metal film as the plasmon-generating layer is not limited to the (pure) aluminum film, and the metal film can be formed by an aluminum alloy film composed of an alloy of aluminum and silver. According to the metal film of such a structure, a surface plasmon frequency (SP frequency) at an interface between the AlN barrier layer and the aluminum alloy film can be modulated to energy corresponding to a low wavelength compared with the SP frequency related to the aluminum film because silver is lower in plasma frequency than aluminum. Accordingly, high luminous efficiency can be achieved on ultraviolet light within a wavelength range longer than the wavelength of the light strengthened in the semiconductor multilayer film element constructed by the metal film composed of the pure aluminum film.

In the above-described embodiment, the construction that the electron beam irradiation source is arranged in opposition to the metal film in the semiconductor multilayer film element, and the electron beams are struck from the side of the metal film has been described. However, the construction that the electron beams are struck from a surface (substrate side) opposing the surface on which the metal film has been formed may be adopted. In such construction, a light extraction surface consists with an incident surface of the electron beams in the semiconductor multilayer film element.

In addition, in the ultraviolet irradiation device according to the present invention, plural semiconductor multilayer film elements may be arranged.

Specifically, the construction that in the ultraviolet irradiation device of the construction illustrated in, for example, FIG. 1, two semiconductor multilayer film elements different in emission wavelength from each other of a semiconductor multilayer film element whose emission wavelength is 250 nm, and a semiconductor multilayer film element whose emission wavelength is 310 nm are arranged side by side in opposition to the electron beam irradiation source may be adopted. Here, the quantum well layer in the semiconductor multilayer film element of the construction exemplified above is formed by $Al_{0.3}Ga_{0.7}N$ in a state that the well width (thickness) thereof is 2 nm, whereby a semiconductor multilayer film element whose emission wavelength is 310 nm can be obtained.

In such construction, a grain structure that the grain size of Al is, for example, 100 to 150 nm is formed at the interface of the aluminum film, whereby the conversion efficiency from the SPP to the photon can be improved in ultraviolet light of both wavelengths of 250 nm and 310 nm.

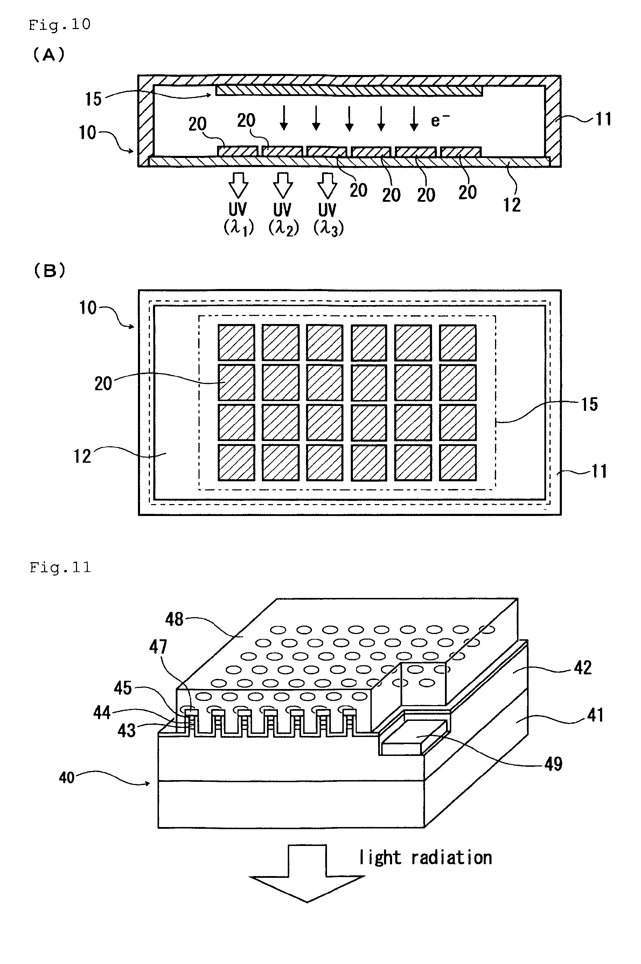

In addition, the construction that plural semiconductor multilayer film elements 20, for example, twenty four elements are arranged in parallel in opposition to the electron beam irradiation source 15 as illustrated in, for example, FIGS. 10(A) and 10(B), and all the semiconductor multilayer film elements 20 are irradiated with electron beams from the common electron beam irradiation source 15 may also be adopted. In such construction, semiconductor multilayer film elements different in emission wavelength from one another are used as the semiconductor multilayer film elements 20, whereby an ultraviolet irradiation device 10 by which plural peak wavelengths ($\lambda$1, $\lambda$2, $\lambda$3, ···) are obtained can be obtained.

REFERENCE SIGNS LIST

|    |    |
|----|----|
| 10 | Ultraviolet irradiation device |
| 11 | Vacuum container |
| 12 | Ultraviolet-ray transmitting window |
| 15 | Electron beam irradiation source |
| 20 | Semiconductor multilayer film element |
| 21 | Substrate (sapphire substrate) |
| 22 | Buffer layer (AIN buffer layer) |
| 25 | Active layer |
| 26 | Quantum well layer (AlGaN quantum well layer) |
| 26A | Uppermost quantum well layer |
| 27 | Barrier layer (AIN barrier layer) |
| 27A | Uppermost barrier layer |
| 30 | Metal film (aluminum film) |
| 40 | Semiconductor light-emitting element |
| 41 | Transparent substrate |
| 42 | n-type contact layer |
| 43 | Active layer |
| 44 | Overflow-inhibiting layer |
| 45 | p-type contact layer |
| 47 | p electrode |
| 48 | Plasmon-generating layer |
| 49 | n electrode |
| G | Crystal grain |
| B | Interface |
| Lc | Light cone |

**EP 2 475 015 B1**

**Claims**

1. An ultraviolet irradiation device comprising at least one semiconductor multilayer film element and an electron beam irradiation source for irradiating the semiconductor multilayer film element with electron beams which are provided in a container having an ultraviolet-ray transmitting window and vacuum-sealed, wherein
the semiconductor multilayer film element has an active layer formed of $In_xAl_yGa_{1-x-y}N$ (wherein $0 \leq x < 1$, $0 < y \leq 1$, and $x + y \leq 1$) and having a single quantum well structure or a multiple quantum well structure and a metal film formed on an upper surface of the active layer, composed of metal particles of aluminum or an aluminum alloy and having a nano-structure formed of the metal particles, and wherein
ultraviolet light is emitted to the outside through the ultraviolet-ray transmitting window by irradiating the semiconductor multilayer film element with the electron beams from the electron beam irradiation source.

2. The ultraviolet irradiation device according to claim 1, wherein the metal particles forming the metal film have a particle size within a range represented by the following expression (1):
[Math. 1]

Expression(1)

$$\frac{\lambda}{\sqrt{\frac{\varepsilon'_m(\lambda)\varepsilon_b(\lambda)}{\varepsilon'_m(\lambda)+\varepsilon_b(\lambda)}} + \sqrt{\varepsilon_b(\lambda)}} \leq a \leq \frac{\lambda}{\sqrt{\frac{\varepsilon'_m(\lambda)\varepsilon_b(\lambda)}{\varepsilon'_m(\lambda)+\varepsilon_b(\lambda)}} - \sqrt{\varepsilon_b(\lambda)}}$$

wherein $\lambda$ is a wavelength [nm] of the ultraviolet light emitted from the semiconductor multilayer film element, a is the particle size [nm] of the metal particles forming the metal film, $\varepsilon'_m(\lambda)$ is a real part of a dielectric function of the metal film, and $\varepsilon_b(\lambda)$ is a dielectric function of a semiconductor layer in contact with the metal film.

3. The ultraviolet irradiation device according to claim 2, wherein the wavelength of the ultraviolet light emitted from the semiconductor multilayer film element is within a range of 220 to 370 nm.

4. The ultraviolet irradiation device according to any one of claims 1 to 3, wherein the metal film in the semiconductor multilayer film element is irradiated with the electron beams from the electron beam irradiation source.

5. The ultraviolet irradiation device according to any one of claims 1 to 4, wherein the semiconductor multilayer film element is arranged on an inner surface of the ultraviolet-ray transmitting window, and the electron beam irradiation source is arranged in opposition to the metal film in the semiconductor multilayer film element.

**Patentansprüche**

1. UV-Bestrahlungsvorrichtung, umfassend wenigstens ein Halbleiter-Mehrschichtfilmelement und eine Elektronenstrahl-Bestrahlungsquelle zum Bestrahlen des Halbleiter-Mehrschichtfilmelementes mit Elektronenstrahlen, die in einem Behälter vorgesehen sind, der ein UV-Strahlendurchlassfenster hat und vakuumverschlossen ist, wobei das Halbleiter-Mehrschichtfilmelement eine aktive Schicht hat, die aus $In_xAl_yGa_{1-x-y}N$ ausgebildet ist (wobei $0 \leq x < 1$, $0 < y \leq 1$ und $x + y \leq 1$), und eine Einzelquantentopfstruktur oder eine Mehrfachquantentopfstruktur sowie einen Metallfilm hat, der auf einer Oberseite der aktiven Schicht ausgebildet ist, bestehend aus Metallpartikeln aus Aluminium oder einer Aluminiumlegierung, und der eine Nanostruktur aufweist, die aus den Metallpartikeln ausgebildet ist, und
UV-Licht nach außen durch das UV-Strahlendurchlassfenster durch Bestrahlen des Halbleiter-Mehrschichtfilmelementes mit den Elektronenstrahlen aus der Elektronenstrahl-Bestrahlungsquelle emittiert wird.

2. UV-Bestrahlungsvorrichtung nach Anspruch 1, bei der die Metallpartikel, die den Metallfilm bilden, eine Partikelgröße innerhalb eines Bereiches haben, der durch den folgenden Ausdruck (1) dargestellt ist:
[Math. 1]

13

Ausdruck (1)

$$\frac{\lambda}{\sqrt{\dfrac{\varepsilon'_m(\lambda)\,\varepsilon_b(\lambda)}{\varepsilon'_m(\lambda)+\varepsilon_b(\lambda)}}+\sqrt{\varepsilon_b(\lambda)}} \le a \le \frac{\lambda}{\sqrt{\dfrac{\varepsilon'_m(\lambda)\,\varepsilon_b(\lambda)}{\varepsilon'_m(\lambda)+\varepsilon_b(\lambda)}}-\sqrt{\varepsilon_b(\lambda)}}$$

wobei λ eine Wellenlänge [nm] des ultravioletten Lichtes ist, das von dem Halbleiter-Mehrschichtfilmelement emittiert wird, a die Partikelgröße [nm] der Metallpartikel ist, die den Metallfilm bilden, $\varepsilon'_m(\lambda)$ ein realer Teil einer dielektrischen Funktion des Metallfilms ist und $\varepsilon_b(\lambda)$ eine dielektrische Funktion einer Halbleiterschicht ist, die mit dem Metallfilm in Kontakt ist.

3.  UV-Bestrahlungsvorrichtung nach Anspruch 2, bei der die Wellenlänge des UV-Lichtes, das von dem Halbteiter-Mehrschichtfilmelement emittiert wird, in einem Bereich zwischen 220 und 370 nm liegt.

4.  UV-Bestrahlungsvorrichtung nach einem der Ansprüche 1 bis 3, bei der der Metallfilm in dem Halbleiter-Mehrschichtfilmelement mit den Elektronenstrahlen aus der Elektronenstrahl-Bestrahlungsquelle bestrahlt wird.

5.  UV-Bestrahlungsvorrichtung nach einem der Ansprüche 1 bis 4, bei der das Halbleiter-Mehrschichtfilmelement auf einer Innenoberfläche des UV-Strahlendurchlassfensters angeordnet ist und die Elektronenstrahl-Bestrahlungsquelle gegenüber dem Metallfilm in dem Halbleiter-Mehrschichtfilmelement angeordnet ist.

**Revendications**

1.  Dispositif d'irradiation à rayonnement ultraviolet, comprenant au moins un élément de film multicouche semi-conducteur et une source d'irradiation à faisceaux d'électrons pour irradier l'élément de film multicouche semi-conducteur avec des faisceaux d'électrons qui sont pourvus dans un conteneur comportant une fenêtre de transmission de rayonnement ultraviolet et scellé sous vide, dans lequel
l'élément de film multicouche semi-conducteur comporte une couche active formée par de l'$In_xAl_yGa_{1-x-y}N$ (où $0 \le x < 1$, $0 < y \le 1$ et $x + y \le 1$) ainsi qu'une structure à puits quantique unique ou une structure à puits quantiques multiples et un film métallique formés sur une surface supérieure de la couche active, composée de particules métalliques d'aluminium ou d'un alliage d'aluminium et présentant une nanostructure formée de particules métalliques, et dans lequel
de la lumière ultraviolette est émise vers l'extérieur à travers la fenêtre de transmission de rayonnement ultraviolet en irradiant l'élément de film multicouche semi-conducteur avec les faisceaux d'électrons provenant de la source d'irradiation à faisceaux d'électrons.

2.  Dispositif d'irradiation à rayonnement ultraviolet selon la revendication 1, dans lequel les particules métalliques formant le film métallique présentent une taille de particule comprise dans une plage représentée par l'expression suivante (1) :

$$\frac{\lambda}{\sqrt{\dfrac{\varepsilon'_m(\lambda)\,\varepsilon_b(\lambda)}{\varepsilon'_m(\lambda)+\varepsilon_b(\lambda)}}+\sqrt{\varepsilon_b(\lambda)}} \le a \le \frac{\lambda}{\sqrt{\dfrac{\varepsilon'_m(\lambda)\,\varepsilon_b(\lambda)}{\varepsilon'_m(\lambda)+\varepsilon_b(\lambda)}}-\sqrt{\varepsilon_b(\lambda)}}$$

Expression (1)

dans laquelle λ est une longueur d'onde [nm] de la lumière ultraviolette émise par l'élément de film multicouche semi-conducteur, a est la taille de particule [nm] des particules métalliques formant le film métallique, $\varepsilon'_m(\lambda)$ est la partie réelle d'une fonction diélectrique du film métallique, et $\varepsilon_b(\lambda)$ est la fonction diélectrique d'une couche semi-conductrice en contact avec le film métallique.

**3.** Dispositif d'irradiation à rayonnement ultraviolet selon la revendication 2, dans lequel la longueur d'onde de la lumière ultraviolette émise par l'élément de film multicouche semi-conducteur est comprise dans une plage allant de 220 nm à 370 nm.

**4.** Dispositif d'irradiation à rayonnement ultraviolet selon l'une quelconque des revendications 1 à 3, dans lequel le film métallique compris dans l'élément de film multicouche semi-conducteur est irradié avec les faisceaux d'électrons provenant de la source d'irradiation à faisceaux d'électrons.

**5.** Dispositif d'irradiation à rayonnement ultraviolet selon l'une quelconque des revendications 1 à 4, dans lequel l'élément de film multicouche semi-conducteur est agencé sur une surface interne de la fenêtre de transmission de rayonnement ultraviolet, et la source d'irradiation à faisceaux d'électrons est agencée en opposition au film métallique dans l'élément de film multicouche semi-conducteur.

Fig.1

Fig.2

Fig.3

Fig.4

Fig.5

Fig.6

Fig.7

Fig.8

Fig.9

Fig.10

(A)

(B)

Fig.11

light radiation

**EP 2 475 015 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4130163 B

- JP 2007214260 A

**Non-patent literature cited in the description**

- *Monthly Display,* February 2009, 10-16